# EUROPÄISCHE PATENTSCHRIFT

(11) **EP 0 677 986 B1**
(45) Veröffentlichungstag und Bekanntmachung des Hinweises auf die Patenterteilung: **25.08.1999**
(21) Anmeldenummer: 95103911.4
(22) Anmeldetag: 17.03.1995
(51) Int. Cl.: H05K 7/14

(54) **Baugruppe eines Automatisierungsgeräts**
Assembly of an automation apparatus
Elément d'un appareil d'automatisation

(30) Priorität: 24.03.1994 DE 4410171
(43) Veröffentlichungstag der Anmeldung: 18.10.1995
(73) Patentinhaber: Schneider Automation GmbH, 63500 Seligenstadt (DE)
(72) Erfinder: Zimmermann, Helmut, D-63546 Hammersbach (DE); Polly, Edgar, D-63500 Seligenstadt (DE)
(74) Vertreter: Stoffregen, Hans-Herbert, Dr. Dipl.-Phys.

(56) Entgegenhaltungen:
- EP-A- 0 268 016
- EP-A- 0 520 410
- DE-A- 3 603 750
- DE-U- 7 531 053
- DE-U- 8 910 111
- US-A- 4 516 189
- DRIVE AND CONTROL, Bd. 3, Nr. 2 / 03, 1.Juni 1993 Seiten 46-47, XP 000385806 FUCHS D ET AL 'COST-CUTTER THE KOALA SYSTEM REDUCES CABLING AND THUS TIME AND COSTS FOR SWITCHGEAR INSTALLATIONS'

## Beschreibung

Die Erfindung bezieht sich auf eine Baugruppe eines Automatisierungsgerätes mit einem zweiteiligen Gehäuse, wobei ein rückwärtiger Teil auf einer Tragschiene aufschnappbar ist und ein vorderer Teil in Reihen und in Abständen parallel und mit gleichem Aufbau fluchtend zueinander angeordnete Anschlusselemente für von außen an die Baugruppe herangeführte Leitungen für die Ein- und/oder Ausgabe von Signalen und/oder Betriebsspannungen von oder zu Aktoren sowie Anzeigeelemente aufweist.

Aus der Firmenschrift "Drive and Control", Bd. 3, Nr. 2/3, Juni 1993, Seiten 46-47, Siemens ist eine Baugruppe eines Automatisierungsgerätes bekannt, das zwei in Abständen parallel und mit gleichem Aufbau fluchtend angeordnete Anschlusselemente für Ein- und/oder Ausgabe von Signalen aufweist. Die Anschlusselemente sind dabei fest an einem Gehäuseoberteil befestigt. Zur Überwachung der Signale sind optische Anzeigeelemente vorgesehen, die in einer Reihe oberhalb der Anschlusselemente angeordnet sind.

Die Anschlusselemente sind als Reihenklemmen mit Schraubbefestigung ausgebildet, die fest mit der Baugruppe verbunden sind.

Ferner ist ein Automatisierungsgerät bekannt, das aus auf Tragschienen aufschnappbaren Baugruppenträgern und Baugruppen besteht, die jeweils auf einem Baugruppenträger befestigt werden. Die Baugruppenträger sind über Steuerleitungen miteinander verbindbar. Mit den Baugruppenträgern sind Anschlußblöcke für die externe Verdrahtung verbunden, die je mittels einer Schraube am Baugruppenträger angeschraubt werden. Die Anschlußblöcke bestehen jeweils aus einem Unterteil und einem Deckelteil. Das Unterteil kann je nach Bedarf als Schraubanschluß, Steckanschluß, Crimpanschluß oder in sonstiger bekannter Art ausgebildet sein (DE 36 03 750 C2).

Bekannt ist auch eine Baugruppe in Modulbauweise, die einen Rahmen aufweist, der zwei rechtwinklig zueinander verlaufende Schenkel hat. An den vertikalen Längsseiten der Schenkel sind einerseits Kontakte zum Verbinden mit Kontakten benachbarter Baugruppen und andererseits Kontakte zum Verbinden mit Kontakten einer vertikalen Leiterplatte vorgesehen. Diese Leiterplatte befindet sich in einem quaderförmigen Baugruppengehäuse, das an den vertikalen Seiten der Schenkel befestigt ist. Der eine Schenkel wird zum Montieren der Baugruppe in eine horizontale Profilschiene eingerastet und weist dann eine vertikale Ausrichtung auf. Der andere, im montierten Zustand der Baugruppe horizontal ausgerichtete Schenkel hat auf seiner Oberseite Vorsprünge, die Kammern mit Klemmverbindern zum Anschluß externer Drähte enthalten. Die Vorsprünge können treppenstufenartig mit Reihen von Klemmverbindern ausgebildet sein (DE 35 04 712 A1).

Eine bekannte Vorrichtung zur Aufnahme von elektrischen bzw. elektronischen Schaltungen besteht aus einem plattenförmigen Baugruppenträger mit leistenförmigen, an den Enden hakenförmig abgewinkelten Vorsprüngen zum Einhaken von kastenförmigen Flachbaugruppen, die auf dem Baugruppenträger nebeneinander angeordnet werden. Jede kastenförmige Flachbaugruppe weist eine Leiterplatte auf, an deren frontseitigem Ende eine Steckerleiste angeschraubt ist, deren rückwärtige Anschlußfahnen mit Leiterplatten auf der Leiterplatte verbunden sind. Die Steckerleiste, die in montierter Stellung der Flachbaugruppe vertikal ausgerichtet ist, enthält nach vorne ragende Messerkontakte, mit denen Kontaktfedern einer Steckeinheit verbindbar sind, die an der Steckerleiste abnehmbar befestigt wird. Die Steckeinheit hat Schraubanschlüsse zum Anschließen externer Leitungen, die bei montierter Steckeinheit in einem vertikalen Kabelkanal verlaufen, der von einer Seite der Steckeinheit, einer Seite eines mit Leuchtdioden versehenen Vorsprungs der Flachbaugruppe, einer frontseitigen Beschriftungsplatte und einer tiefer liegenden Seite der Flachbaugruppe eingeschlossen wird (DE 34 18 844 C2).

Ein bekanntes Leergerät für mittlere und kleinere Steuerungen enthält einen Gehäusebecher, der mit einem Frontdeckel verschließbar ist. Der nach vorne offene Gehäusebecher ist an seiner Rückseite an einer Profilschiene befestigbar. Der Frontdeckel hat nahe an seinem oberen und unteren Rand jeweils eine Reihe von Schraubklemmen für den Anschluß externer Leitungen. Im Frontdeckel ist eine Öffnung zum Einsetzen einer Steckkarte vorgesehen. Nahe an der rückwärtigen Wand im Inneren des Gehäusebechers ist eine Steckverbinderleiste vorgesehen, in die Kontaktbahnen der Steckkarte einfügbar sind. Im Gehäusebecher sind weitere Leiterplatten angeordnet (DE-GM 75 31 053).

Schließlich ist ein Automatisierungsgerät mit wenigstens einem auf eine Tragschiene aufschnappbaren Baugruppenträger bekannt, der für die Befestigung mehrerer Baugruppen angelegt ist, die jeweils als kastenförmige Flachbaugruppen ausgebildet sind. Die Baugruppen sind modular ausgebildet und weisen wenigstens auf ihrer Oberseite Lüftungsgitter auf. Jede Baugruppe ist in einen am Baugruppenträger vorspringenden Haken einhängbar, der eine Querleiste des Lüftungsgitters umgreift.

Die Baugruppen sind mit Frontplatten versehen, die in montierter Lage vertikal ausgerichtete Steckverbinderleisten zum lösbaren Anschluß von Messerleisten enthalten, die Schraubklemmen für den Anschluß externer Leitungen aufweisen (DE 89 10 111 U1).

Der Erfindung liegt das Problem zugrunde, eine Baugruppe eines Automatisierungsgeräts zu entwickeln, die bei möglichst einfachem Aufbau den Anschluß der Leitungen externer Stell- und oder Sensorgeräte in übersichtlicher, einfach zuordenbarer Weise mit geringem Aufwand ermöglicht. Dabei soll die zwei oder mehreren unterschiedlichen Pegeln entsprechende Potentialbelegung der Leitungen mit optischen Anzeigeelementen in schnell erkennbarer Zuordnung zu den angeschlossenen Leitungen möglich sein. Die externen Leitungen sollen bereits vor der Verbindung mit der Baugrupe in die vorgesehene Reihenfolge in den für die Anschlüsse bestimmten Abständen festgelegt werden können.

Das Problem wird bei einer Baugruppe der eingangs beschriebenen Art erfindungsgemäß dadurch gelöst, daß die Baugruppe wenigstens eine mit Bauelementen mindestens einer elektrischen Schaltung bestückte Leiterplatte enthält, auf der wenigstens drei Steckverbinderleisten angeordnet sind, daß jeweils drei Kontaktelemente je aus einer Steckverbinderleiste längs einer geraden Linie angeordnet und jeweils für Signaleingabe-, Signalausgabe oder für Betriebsspannungen vorgesehen sind, daß der vordere Teil mit Ausnehmungen einerseits für den Zugang zu den Steckverbinderleisten und andererseits als Fenster für auf der Leiterplatte angeordnete optische Anzeigeelemente versehen ist, die jeweils längs der Linie in Abstand von den Kontaktelementen angeordnet sind und Pegel auf diesen Kontaktelementen anzeigen, und daß auf den Steckverbinderleisten Gegensteckverbinderleisten befestigbar sind, an deren Kontaktelementen die Enden der von außen herangeführten Leitungen befestigt sind.

Die vorstehend beschriebene Baugruppe erlaubt den übersichtlichen Anschluß der Leitungen von Stell- und Sensoreinheiten, die jeweils zwei drei oder mehrere Leitungen aufweisen. Diese drei oder mehrere Leitungen belegen die längs einer Linie angeordneten Kontaktelemente der drei Steckverbinderleisten, die vorzugsweise als Federleisten ausgebildet sind. Für viele industrielle Anlagen bestehen Vorschriften über die Art der steuerungsseitigen Anschlußtechnik von Leitungen, die von Geräten, Stellgliedern und Sensoren zu Steuergeräten wie Automatisierungsgeräten verlegt sind. Diese Vorschriften besagen, daß die Enden der Leitungen mit Kontaktelementen in übersichtlicher Weise verbunden werden müssen. Übersichtlich bedeutet hierbei, daß die je zu einem Gerät, z. B. einem Sensor oder einem Stellglied, gehörenden Leitungen in einem Anschlußschema angeschlossen werden, das sofort die Zugehörigkeit der Leitungen und die Art der Leitungen, z. B. Erdleitungen, zu einer Einheit erkennen läßt. Die bisher auch in Verbindung mit speicherprogrammierbaren Steuerungen üblichen Anschlußtechniken erfüllen diese Vorschriften, indem die Leitungsenden der externen Einheiten an z. B. Reihen-Klemmen unter Beachtung eines Anschlußschemas angeschlossen werden, das vorsieht, daß bei den Geräten eine bestimmte Reihenfolge bezüglich Signalein- oder -ausgangsleitungen, Betriebsspannungsleitungen und Nulleitungen eingehalten wird. Von diesen Klemmen werden dann weitere Leitungen zu den Anschlußkontakten des jeweiligen Automatisierungsgeräts verlegt, dessen Anschlußkontakte eine solche übersichtliche Anordnung nicht zulassen, weil z. B. keine der Anzahl der angeschlossenen externen Einheit entsprechende Zahl von Kontaktelementen am Automatisierungsgerät vorhanden ist. Bei der erfindungsgemäßen Baugruppe sind demgegenüber an bzw. in Aussparungen des Gehäuses durch die parallelen Steckverbinderleisten genügend Anschlußkontakte für zwei- oder dreileitrige oder mehrleitrige externe Geräte vorgesehen, bei denen es sich um die Mehrzahl der kommerziell verfügbaren Sensoren oder Stellglieder handelt. Sensoren, z. B. kontaktlose Näherungsinitiatoren, benötigen überwiegend drei Leitungen, von denen eine eine Signalleitung ist, während die beiden anderen die Betriebsspannung übertragen. Falls nur zwei Leitungen wie bei Endschaltern benötigt werden, kann das Kontaktelement in einer Steckverbinderleiste unbelegt bleiben. Falls externe Einheiten mit vier oder mehr Leitungen verwendet werden, ist die Anzahl der Steckverbinderleisten entsprechend anzupassen. Vorzugsweise ist auf der Leiterplatte eine zu den Steckverbinderleisten parallele Stromschiene angebracht, die wenigstens eine der Anzahl der Kontaktelemente der Steckverbinderleisten entsprechende Zahl von Anschlußelementen hat, die je in einer Linie mit zugeordneten Kontaktelementen der Steckverbinderleisten liegen und über eine Aussparung im vorderen Teil des Gehäuses zugänglich sind. Bei dieser Ausführungsform ist für jede externe Einheit neben dem Signal- und Betriebsspannungsanschluß ein Anschluß als Potentialstützpunkt oder wahlweise auch für den Schutzleiter vorhanden, wodurch die Baugruppe in übersichtlicher, klarer Form die Stellen für die externen Einheiten erkennen läßt. Die Steckverbinderleisten und die Potentialstützpunkte sind insbesondere in montierter Stellung der Baugruppe waagrecht im unteren Bereich des Gehäuses angeordnet. Die externen Leitungen werden von unten kommend an die Baugruppe angeschlossen.

Es ist zweckmäßig, wenn auf einem Wandabschnitt des Gehäuses, der an die Fenster für die optischen Anzeigeelemente angrenzt, ein Beschriftungsfeld mit Abschnitten, die zu den einer externen Einheit zugeordneten Kontaktelementen der Steckverbinderleisten und den zugeordneten und optischen Anzeigen fluchten, angeordnet ist.

Auf den Abschnitten können Informationen über die angeschlossenen externen Einheiten angebracht werden, zumindest wird eine, den Kontaktelementen zugeordnete Kennziffer, die z.B. in Schalt- oder Stromlaufplänen enthalten ist, angebracht, wodurch sich die zu einer externen Einheit verlegten Leitungen eindeutig identifizieren lassen.

Obwohl auf der Leiterplatte und in bezug auf die Fenstergröße Vorkehrungen für eine der Anzahl der Steckverbinderleisten entsprechende Anzahl von optischen Anzeigeelementen je externer Einheit getroffen sind, ist es vielfach nicht notwendig, für jedes Kontaktelemet einer Reihe, die einer externen Einheit zugeordnet ist, ein optisches Anzeigeelement wie Leuchtdiode usw. vorzusehen.

Werden mehrere gleichartige externe Einheiten angeschlossen, die gleiche Betriebsspannungen erhalten, dann reicht beispielsweise ein optisches Anzeigeelement für die Anzeige der Betriebsspannung dieser Einheiten aus. Auf diese Weise können Anzeigeelemente eingespart werden.

Die Steckverbinderleisten auf der Leiterplatte sind vorzugsweise als Messerleisten ausgebildet, in die wahlweise Federzug-/Steckklemmen oder Schraub-/Steckklemmen einfügbar sind, wobei die Messerleisten an den Stirnseiten mit von Hand betätigbaren Auswerfern für die Federzug-/Steckklemmen oder Schraub-/Steckklemmen versehen sind. Die Wahl der Steckklemme kann sich dabei nach den in der jeweiligen technischen Anlage für andere Geräte verwendeten Klemmen richten.

Vorzugsweise sind die Messerleisten und die Schraub-/Steckklemmen oder Federzug-/Steckklemmen je mit mechanischen Codiermitteln versehen. Die Codierung wird für jede der Messerleisten der Baugruppe verschieden eingestellt. Es handelt sich z. b. um Sicherheitscodierung, die ein Verschleppen gefährlicher Spannung in den Kleinspannungsbereich verhindert. Individuelle Codierung durch den Anwender ist ebenfalls möglich. Dadurch können Falschbelegungen der Messerleisten vermieden werden. Für die Codierung sind insbesondere Taschen und Codierleisten an den Steckverbindern vorgesehen.

Der vordere Teil des Gehäuses der Baugruppe weist vorzugsweise einen die Steckverbinderleiste umgehenden externen Abschnitt mit kleinerer Tiefe und einen an den ersten Abschnitt angrenzenden zweiten Abschnitt mit größerer Tiefe auf.

Im zweiten Abschnitt können großvolumigere Bauelemente der Schaltung angeordnet werden, während der erste Abschnitt vor allem denjenigen Teil der Leiterplatte einschließt, der die Steckverbinderleisten und die optischen Anzeigeelemente trägt. In der Stufe zwischen dem ersten und zweiten Abschnitt und in der Wand des Gehäuses, die der Stufe entgegengesetzt ist, befinden sich zweckmäßigerweise Lüftungsöffnungen. Die Lüftungsöffnungen können die Form von Schlitzen haben.

Es ist günstig, wenn an zwei Ecken der Leiterplatte, die der Seite mit den Steckverbinderleisten entgegengesetzt sind, je ein Steckverbinder angebracht ist, der im zweiten Abschnitt des ersten Teils des Gehäuses über eine Öffnung zugänglich ist, die in der Wand, die der Stufe entgegengesetzt ist, vorgesehen ist. Wenn die Baugruppe an waagrechten Tragschienen montiert ist, sind die Steckverbinder nach oben gerichtet.

Baugruppen können daher auf der Tragschiene nebeneinander angeordnet werden, ohne daß diese Anordnung von den externen Leitungen oder von den an die oberen Steckverbinder geführten Leitungen beeinträchtigt wird. Die oberen Steckverbinder sind vorzugsweise für den Anschluß eines Busses bestimmt, bei dem es sich insbesondere um einen Fernbus handelt, an den mehrere Baugruppen angeschlossen werden können.

Auf der Leiterplatte ist, wie vielfach üblich, eine Bahn oder größere Flächen für Erdungszwecke vorgesehen. Vorzugsweise ist ein größerer Abschnitt dieser Bahn oder Fläche auf der Leiterplatte in Höhe der Tragschiene vorgesehen und gegen eine im hinteren Teil des Gehäuses gehaltene Feder andrückbar, die durch eine Aussparung des hinteren Teils in den Raum außerhalb des Gehäuses ragt und bei aufgeschnappter Baugruppe an der Tragschiene anliegt. Über die Tragschiene und die Feder wird eine niederohmige Masseverbindung hergestellt, die einen guten Schutz gegen elektromagnetische Störungen bietet. Das Gehäuse besteht vorzugsweise aus Polykarbonat-Kunststoff. Daher ist das Gehäuse gut recyclebar.

Der vordere Teil des Gehäuses kann eine Farbcodierung tragen, die insbesondere angibt, daß höhere Spannungen, z. B. Netzspannung, als Eingabe- oder, Ausgabespannung verwendet werden. Die Baugruppe kann eine Eingabe-, Ausgabebaugruppe eines Automatisierungssystems sein.

In diesem Fall wird eine einzige Leiterplatte im Gehäuse für die Schaltungsanordnung ausreichen. Andererseits kann die Baugruppe eine komplette speicherprogrammierbare Steuerung mit Eingabe-, Ausgabebauelementen, wenigstens einem Mikroprozessor und Speichern sein.

Die Erfindung wird im folgenden anhand eines in einer Zeichnung dargestellten Ausführungsbeispiels näher beschrieben, aus dem sich weitere Einzelheiten, Merkmale und Vorteile ergeben.

Es zeigen:
- Fig. 1: eine perspektivische Ansicht einer Baugruppe von vorne;
- Fig. 2: eine weitere perspektivische Ansicht einer Baugruppe in einer Richtung schräg von unten;
- Fig. 3: eine perspektivische Ansicht einer Baugruppe mit komplett bestückten Steckverbindern für den Anschluß externer Einheiten;
- Fig. 4: eine auf einer Tragschiene befestigte Baugruppe schematisch in Seitenansicht;
- Fig. 5a, b: eine Messerleiste und eine Schraub-Steckklemme in Seitenansicht;
- Fig. 6: eine Federzug-Steckklemme in perspektivischer Anslcht;
- Fig. 7: eine Schraub-Steckklemme in perspektivischer Ansicht;
- Fig. 8: eine Stromschiene mit Schraubklemmen in perspektivischer Ansicht;
- Fig. 9: eine Stromschiene mit einer Federzugklemme in perspektivischer Ansicht;
- Fig. 10: eine Ansicht einer Baugruppe von vorne mit einem über drei Leiter angeschlossenen externen Gerät in schematischer Darstellung;
- Fig. 11: eine Ansicht einer Baugruppe von vorne mit einem über vier Leiter angeschlossenen externen Gerät in schematischer Darstellung;
- Fig. 12: eine Ansicht einer Baugruppe von vorne mit zwei, je über drei und zwei Leiter angeschlossenen externen Geräten in schematischer Darstellung;
- Fig. 13: eine Ansicht einer Baugruppe von vorne mit zwei je über drei Leiter angeschlossenen externen Geräten in schematischer Darstellung und
- Fig. 14: eine Baugruppe in Seitenansicht.

Eine Baugruppe 10 eines Automatisierungsgeräts enthält eine Leiterplatte 9 (Fig. 14), auf der sich nicht näher dargestellte elektrische bzw. elektronische Bauelemente einer Schaltungsanordnung befinden, die wenigstens Eingabe-, Ausgabeelemente aufweist, die Signale für Anlagenteile eines technischen Prozesses empfangen oder ausgeben. Die Eingabe-, Ausgabeelemente sind an weitere Bauelemente der Schaltung angeschlossen, die z. b. für eine Eingabe-, Ausgabebaugruppe, die mit anderen gleichartig aufgebauten Baugruppen über einen Bus an eine Zentraleinheit angeschlossen ist, benötigt werden. Die Übertragung von Daten auf den Bus erfordert schon wegen des Busprotokolls eine gewisse "Intelligenz" in der Baugruppe 10. Die Leiterplatte 9 befindet sich in einem zweiteiligen Gehäuse.

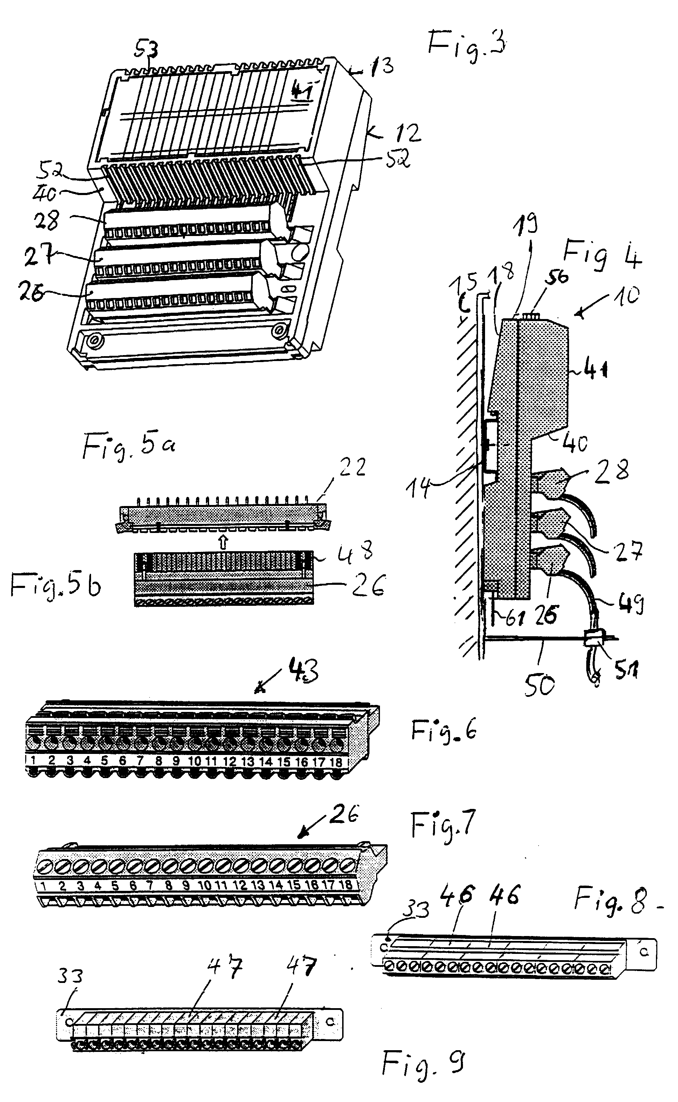

Der hintere Teil 12 des Gehäuses ist für die Befestigung an einer Tragschiene 14 ausgebildet, die z. B. genormt ist. Die Tragschiene 14 ist beispielsweise an der hinteren Wand 15 (Fig. 4) eines Gehäuses befestigt, wie es im industriellen Einsatz in Fabriken bzw. Gebäuden vielfach benutzt wird, wenn eine höhere Schutzart gefordert ist.

Eine parallel zur jeweiligen Wand verlaufende Bodenplatte 16 des hinteren Teils erstreckt sich ungefähr bis zur Mitte des Teils 12. In der Mitte weist das Teil 12 eine quer über die Breite verlaufende Vertiefung 17 auf, die an die Abmessungen der Tragschiene 14 derart angepaßt ist, daß die in die Vertiefung 17 eingesetzte Tragschiene 14 mit dem Bodenteil das hintere Teil 12 etwas überragt.

Im Anschluß an die Vertiefung 17 verläuft das hintere Teil mit einem schrägen Wandabschnitt 18 bis zu einer oberen, in Einbaulage der Baugruppe 10 waagrecht verlaufenden Wand 19.

Der vordere Teil 13 des Gehäuses hat im wesentlichen einen ersten Abschnitt 20, der sich in der Einbaulage des Gehäuses unten befindet, und einen zweiten Abschnitt 21, der in der Einbaulage des Gehäuses oben angeordnet ist.

Auf der Leiterplatte 9 sind im Bereich des unteren Abschnitts 20 Steckverbinderleisten 22, 23, 24 im Abstand parallel zueinander angeordnet. Die Steckverbinderleisten 22, 23, 24 sind Messerleisten und werden im folgenden auch als solche bezeichnet. Es können aber auch Federleisten sein.

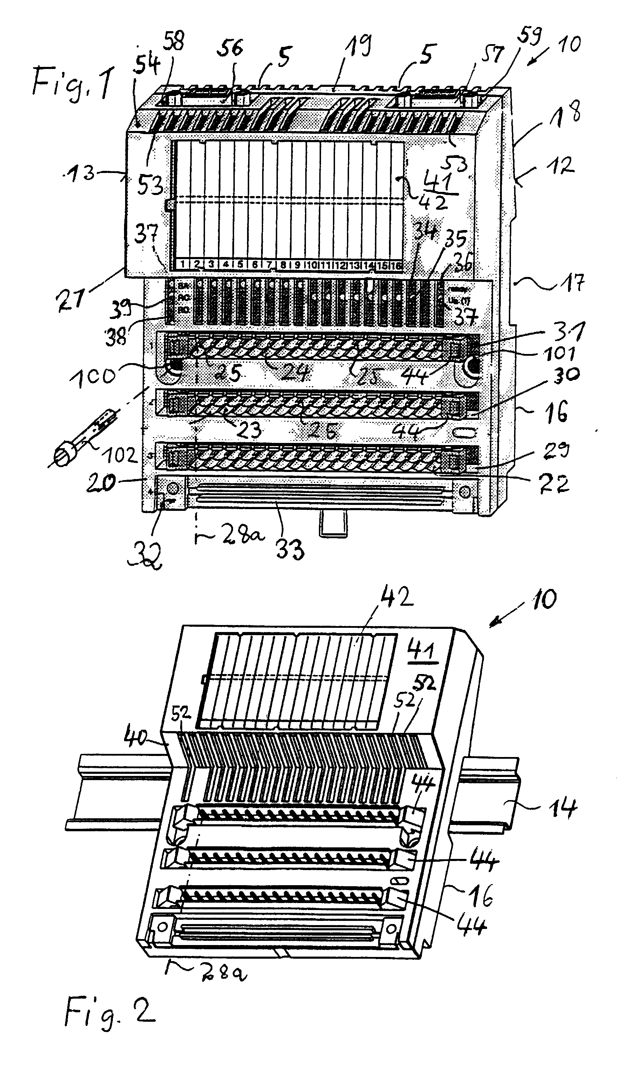

Die Fig. 1 zeigt die Messerleisten 22, 23, 24 perspektivisch von vorne. Die Messerleisten 22, 23, 24 haben Stifte 25 für die Verbindung mit Federleisten von unten noch näher beschriebenen Steckverbinderleisten 26, 27, 28, bei denen es sich um Federleisten handelt, wenn die Steckverbinderleisten 22, 23, 24 Meserleisten sind.

Die Messerleisten 22, 23, 24 sind gleich und z. B. sechzehnpolig oder insbesondere achtzehnpolig ausgebildet. Sie sind so auf der Leiterplatte 9 befestigt, daß sie zueinander fluchten.

Dies bedeutet, daß von jeder Messerleiste drei oder mehrere Messer bzw. Stifte in Einbaulage des Gehäuses längs einer senkrechten Linie angeordnet ist. Es handelt sich um die mit 28a bezeichnete Linie, die in Fig. 1 und 2 dargestellt ist. Die Anordnung jeweils dreier, zu den verschiedenen Messerleisten 22, 23, 24 gehörenden Messer bzw. Stifte 25 längs parallelen, in Einbaulage senkrechten Linien 28a hat folgenden Zweck. Die drei Stifte sind jeweils schaltungsmäßig einer externen Einheit zugeordnet. In Sonderfällen können auch mehr als eine Einheit an die einer Einheit zugeordneten Stifte angeschlossen werden. Die Messerleisten 22, 23, 24 ragen durch entsprechend ausgebildete Aussparungen 29, 30, 31 im Teil 13 hindurch, sind also von außen zugänglich.

Am unteren Rand des Teils 13 ist eine weitere Aussparung 32 vorgesehen. Im Bereich dieser Aussparung sitzt auf der Leiterplatte 9 eine Strom- bzw. Erdungsschiene 33, die für jeden Stift 25 eine Anschlußstelle hat. Externe, im Prozeß befindliche Geräte werden an die Baugruppe 10 angeschlossen. Vielfach handelt es sich bei diesen, im folgenden auch als Aktoren bezeichnete Geräte um Endschalter, Näherungsinitiatoren, Lichtschranken, Relais, Schütze und Magnetventile. Die meisten dieser Aktoren kommen mit vier oder weniger Anschlußleitungen aus. Wenn der Aktor keine Schutzisolierung hat, wird der Schutzleiter des Aktors an die Erdungsschiene 33 auf unten noch näher beschriebene Weise angeschlossen. Zwei Leitungen sind im allgemeinen für die Versorgung mit Betriebsspannung erforderlich. Die dritte Leitung ist für die Übertragung eines binären Signals bestimmt, an dem der Betriebszustand des Aktors feststellbar ist.
Relaisspulen benötigen nur zwei Anschlußleitungen, wobei gegebenenfalls ein Schutzleiter für die Erdung der Eisenteile des Relais notwendig ist.

Innerhalb der auf der Leiterplatte 9 angeordneten Schaltung ist jeweils ein Stift 25 einer senkrechten Reihe von Stiften einem Eingang einer Eingabeschaltung zugeordnet, wenn die Baugruppe für die Eingabe binärer Signale ausgebildet ist. Zwei weitere Stifte sind z. B. für die Übertragung der Betriebsspannung zu Aktoren bestimmt. Wenn mehrere gleichartige Aktoren an die Baugruppe angeschlossen werden, können die Ausgänge für Betriebsspannungen gebrückt sein. Zur Steuerung von Stellelementen werden entsprechende Spannungen insbesondere über die Stifte 25 der Messerleisten 24, 23 ausgegeben, während die Stifte der Messerleiste 22 vorzugsweise für Eingabesignale bestimmt sind.

Fluchtend zu den Stiften 25, die längs einer Linie 28a angeordnet sind, weist der Teil 13 auf der der Aussparung 32 entgegengesetzten Seite Aussparungen 34 auf, die parallel zueinander verlaufen und Fensterschlitze bilden. Auf der Leiterplatte 9 sind im Bereich der Fensterschlitze optische Anzeigeelemente 35 in Form von Lumineszenzdioden angeordnet. Die Anzahl der Lumineszenzdioden je Fensterschlitz entspricht maximal der Anzahl der längs der Linie 28a angeordneten Kontaktelemente in Form der Stifte 25. Je nach Art der an die Baugruppe 10 angeschlossenen Aktoren reichen aber vielfach auch weniger aus. Die optischen Anzeigeelemente 35 sind in parallelen Reihen angeordnet und zeigen in binärer Form die Pegel auf zugeordneten Stiften 25 an, wobei die Zuordnung der Anzeigeelemente 35 zu den Stiften 25 in der Reihenfolge von oben nach unten der Reihenfolge der Messerleisten 24, 23, 22 entspricht.

Neben den Anzeigeelementen 35 unter den Fensterschlitzen, die jeweils einer Reihe von Kontaktelementen bzw. Stiften 25 der Messerleisten 22 bis 24 zugeordnet sind, weist das Teil 13 weitere Fensterschlitze 36, 38 auf, durch die auf der Leiterplatte 9 angeordnete Anzeigeelemente 37, 39 oder mehr sichtbar sind, die bestimmte Funktionen anzeigen, z. B. die Betriebsbereitschaft und das Vorhandensein der Betriebsspannung.
Der Abschnitt 20 geht in einer Stufe 40 in den Abschnitt 21 über, dessen vordere Wand 41 einen größeren Abstand vom hinteren Teil des Gehäuses hat als die die Messerleisten 22 bis 24 umgebende Wand des Abschnitts 20, deren Abstand auf die Höhe der Messerleisten 22 bis 24 abgestimmt ist.

Diese Abstimmung soll die einfache Zugänglichkeit der Messerleisten 22 bis 24 gewährleisten, d. h. die Messerleisten 22 bis 24 dürfen nicht zu tief im Gehäuse angeordnet sein und die Aussparungen 29, 30, 31 müssen möglichst nur die Messerleisten und nicht andere Teile im Inneren des Gehäuses freigeben. Auf der Wand 41 ist eine Beschriftungsleiste 42 in Form eines Aufklebers oder Einlegeschildes aufgebracht.

Die Beschriftungsleiste 42 weist, wie sich aus Fig. 1, 2, 3 und 10 - 13 ersehen läßt, Spalten auf, die jeweils fluchtend zu einer Aussparung 34 im Abschnitt 20 verlaufen und gegen die entsprechende Aussparung 34 um die Höhe der Stufe 40 versetzt sind.

Jede Spalte der Beschriftungsleiste 42 ist damit den Anzeigeelementen 36 sowie den zu den Anzeigeelementen 36 gehörigen Kontaktelementen bzw. Stiften 25 der Messerleisten 22 - 24 angeordnet. Die Beschriftungsleiste 42 kann Anschlußklemmenbezeichnungen und andere Informationen enthalten, die sich auf einen Schalt- oder Stromlaufplan und die an die Kontaktelemente bzw. Stifte 25 unterhalb der Anzeigeelemente angeschlossenen Aktoren beziehen.

Auf die Steckkontaktleisten bzw. Messerleisten 22 - 24 sind jeweils Schraub-Steckklemmen 26, 27, 28 (Fig. 3) aufsteckbar, die an sich bekannt sind. Eine Schraub-Steckklemme 26 ist in perspektivischer Ansicht in Fig. 7 dargestellt. Alternativ können statt der Schraub-Steckklemmen 26, 27, 28 auch an sich bekannte Federzug-Steckklemmen verwendet werden. Eine solche Federzug-Steckklemme 43 ist in Fig. 6 dargestellt.

Die Messerleisten 22 bis 24 enthalten an den schmalen Stirnseiten Auswerfelemente 44. Durch Kippen der Auswerfer 44 von Hand in Richtung der jeweiligen Seitenwand des Gehäuses der Baugruppe 10 wird die Federzug- oder Schraub-Steckklemme ausgehebelt, so daß letztere schnell und einfach vom Gehäuse entfernt werden können.

Die von den externen Einheiten zu der Baugruppe 10 verlegten Leitungen, die z. B. Drähte in Kabeln sind, werden mit ihren Enden entweder in den Schraub-Steckklemmen 26 bis 28 festgeschraubt oder in den Federzug-Steckklemmen 43 wartungsfrei geklemmt. Die Wahl der Klemmenart richtet sich nach den jeweiligen Wünschen oder Vorschriften des Anwenders der Baugruppe.

Für die Erdleitungen der externen Einheiten sind entweder an der Stromschlene 33 befestigbare Schraubklemmen 45 oder an der Stromschiene 33 befestigbare Federzugklemmen 46 vorgesehen. Die Stromschiene 33 mit den Schraub- oder Federklemmen ist an der Leiterplatte 14 befestigt.

Durch die Schraub- oder Federzug-Steckklemmen 26 - 28 bzw. 43 und die Schraub- oder Federzugklemmen 46, 47 ist die Befestigung der Leitungsenden der an die Baugruppe 10 anzuschließenden externen Einheiten räumlich getrennt von der Baugruppe 10 möglich. Dies erleichtert die Verdrahtung.

Die mit den Drahtanschlußenden verbundenen Schraub- oder Federzugklemmen werden anschließend in die Messerleisten des Gehäuses eingesteckt. Die Einheit 33, eine potentialstützpunktschiene, kann auch als Schutzleiterschiene eingesetzt werden mit entsprechender Kennzeichnung.

Um Verwechslungen zu vermeiden sind die Messerleisten 22 bis 24 und die Schraub-Steckklemmen 26 bis 28 mechanisch gegen Vertauschung gesichert codiert. Die mechanische Codierung ist anhand der in Fig. 5a, b dargestellten Messerleiste 22 und Schraub-Steckklemme 26 zu ersehen, die beide in Seitenansicht dargestellt sind. Die Schraub-Steckklemme 26 enthält an ihrer Seite eine Stiftleiste, die Codierkeile 48 in einer gewünschten Kombination enthält. In der Messerleiste 22 ist eine Buchsenleiste vorgesehen, die an den Stellen, an denen die Schraub-Steckklemme Codierteile 48 enthält, freie Buchsen aufweist. Auf diese Weise wird sichergestellt, daß nur zwei durch Codierung aufeinander abgestimmte Steckverbinderleisten zusammengefügt werden können.

Die Baugruppen 10 sind je nach Typ für ungefährliche, z. B. Kleinspannungen, oder gefährliche Spannungen (z. B. Netzspannung) einsetzbar. Entsprechend der Spannung sind die Steckverbinderleisten codiert. Nach IEC 364, IEC 950 ist eine Spannung > 42,4 VAC und > 60 VDC als gefährlich anzusehen.

Bei Komponenten, die in beiden Spannungsbereichen betrieben werden können (z. B. Relais) wird werksseitig die Voreinstellung der Codierung auf der Stiftleiste der Module für den gefährlichen Spannungsbereich eingestellt.

Die Baugruppe 10 stellt in übersichtlicher Form Anschlußelemente für externe Einheiten zur Verfügung.

Sowohl für den Monteur, der die Verdrahtung bzw. den Anschluß der Leitungsenden der Drähte der externen Geräte herstellt, als auch für Wartungs- und Servicepersonal sind zumindest anhand von Schaltplänen die Anschlußstellen leicht festzustellen. Hierdurch werden Fehler bei der Verdrahtung vermieden.

Die Baugruppe 10 ermöglicht somit die eindeutige Identifizierung und Zuordnung von Anschlußpunkten von externen Einheiten in bezug auf Schutzleiter, Betriebsspannung, Meldeeingängen oder Ansteuerausgängen. Damit wird die durch die Baugruppe 10 selbst die vielfach in Vorschriften geforderte übersichtliche und leicht zugängliche Anordnung von Verdrahtungsstützpunkten zur Verfügung gestellt. Es ist dann nicht mehr erforderlich, zusätzlich Reihenklemmen auf gesonderten Schienen für die Bildung von Verdrahtungsstützpunkten vorzusehen. Ein an eine Schraub-Steckklemme, z. B. 26, angeschlossenes Kabel 49 kann dann, wenn sich die Baugruppe 10 in einem in Fig. 4 nur teilweise dargestellten Gehäuse 50 befindet, mittels einer Verschraubung 51 in der unteren Wand des Gehäuses 50 zugentlastet befestigt werden, ohne daß zwischen der Schraub-Steckklemme 26 und dem an das Kabel 51 angeschlossenen Aktor, der nicht näher dargestellt ist, weitere zugängliche Anschlußstellen befinden. Die oben beschriebene Anschlußtechnik hat den Vorteil einer erheblichen Einsparung an Material- und Zeitaufwand. Die Leitungsenden der direkt von den externen Einheiten kommenden Leitungen können schnell und einfach ohne zwischenliegende Kontaktstützpunkte mit den Schraub-Steckklemmen 26, 27, 28 oder Federzug-Steckklemmen 43 verbunden werden.

Gleiches gilt für die Schutzleiter, falls solche für ein externes Gerät benötigt werden. Diese Schutzleiter werden über die Schraubklemmen 46 oder Federzugklemmen 47 mit der Stromschiene 33 verbunden.

In der Stufe 40 sind Lüftungsschlitze 52 vorgesehen, wie in den Fig. 2 und 3 dargestellt ist. Auf der Oberseite 54 des Gehäuses des Abschnitts 13 sind ebenfalls Lüftungsschlitze 53 vorhanden. Dies ist in Fig. 1 dargestellt. Die Lüftungsschlitze 52 und die Aussparungen 34 lassen in Verbindung mit den Lüftungsschlitzen 53 eine gute Kühlung der auf der Leiterplatte 9 angeordneten Bauelemente zu. Weitere Kühlschlitze 53 befinden sich in der Wand 19. Durch die vorstehend erwähnten Kühlluftschlitze erfüllt die Baugruppe die Bedingungen einer bestimmten Schutzart, z. B. IP 20. Falls eine höhere Schutzart verlangt wird, wird die Baugruppe in einem Gehäuse, z. B. 50, das für eine höhere Schutzart ausgelegt ist, angeordnet.

Nahe an den oberen Ecken der Leiterplatte 9 sind zwei Steckverbinder 56, 57 angeordnet, die ein Stück über Aussparungen 58, 59 in der Oberseite 54 hinausragen.

Die Steckverbinder 56, 57 sind für den Anschluß an Busleitungen bestimmt und stellen Verbindung zwischen auf der Leiterplatte 9 angeordneten Leiterbahnen eines Busses her. An diesen Bus kann eine Vielzahl von Baugruppen über die Steckverbinder 56, 57 und entsprechende Buskabel angeschlossen werden. Die Steckverbinder 56, 57 ermöglichen einen direkten Anschluß an einen Bus, d. h. sie sind eine unmittelbare Prozeß-Schnittstelle, ohne daß eine Zwischenverdrahtung oder Rangierung notwendig ist.

Im hinteren Teil 12 des Gehäuses ist eine bügelartige Feder 60 gehalten, die eine Leiterbahn der Leiterplatte 9 kontaktiert. Diese Leiterbahn, die nicht näher dargestellt ist, dient Abschirmzwecken. die Feder 60 ragt mit einem Teil durch eine nicht näher dargestellte Öffnung des hinteren Teils 12 nach außen und zwar in Höhe der Tragschiene 14. Wenn die Baugruppe 10 an der Tragschiene 14 befestigt ist, wird die Feder 60 gegen die Tragschiene 14 und gegen einen entsprechend größeren Abschnitt auf der Leiterplatte 9 angedrückt. Die Tragschiene 14 führt Erd- bzw. Massepotential. Durch die relativ kurze Feder 60 wird eine niederohmige, direkte Masseanbindung zwischen Leiterplatte 9 und Montageschiene erreicht, was eine besonders gute und effektive Ableitung von Störspannungen und - strömen bewirkt (Störimpulsen). Im hinteren Teil 12 des Gehäuses ist in der Bodenplatte 16 eine Riegelfeder 61 verschiebbar angeordnet, die die Baugruppe 10 an der Tragschiene 14 verriegelt. Durch die Riegelfeder 61 wird die Baugruppe 10 an der Tragschiene 14 gehalten.

Der vordere Teil 13 des Gehäuses wird mittels nicht näher dargestellter Rasthaken und einer in eine Vertiefung einsetzbare, Kunststoff formende Schraube, die in das vordere Teil 13 eingreift, geschlossen. Das Gehäuse kann daher in kurzer Zeit auf einfache Weise geschlossen oder geöffnet werden. Das Gehäuse besteht aus recyclefähigem Polycarbonat.
Auf der Wand 41 kann eine Gerätefunktionskennzeichnung durch Farbcodierung angebracht werden.

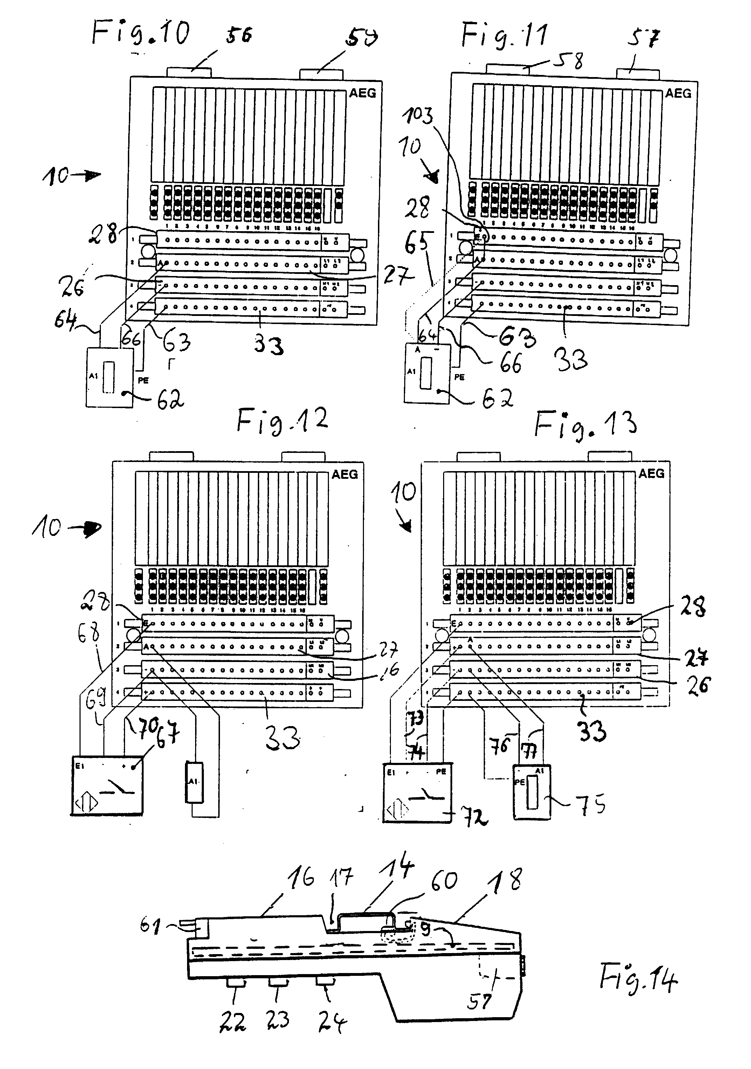

Die Fig. 10 zeigt die Verbindung eines 2/3-Drahtaktors 62 mit den Kontaktelementen der Schraub-Steckklemmen 26, 27 und der Stromschiene 33. Bei dem 2/3-Drahtaktor 62, bei dem es sich z. B. um ein Relais handelt, ist der Schutzleiter 63 mit der Stromschiene 33 verbunden, während die Leitungen 64, 66 an senkrecht untereinander an den Schraub-Steckklemmen liegende Klemmen angeschlossen sind.

Über diese Klemmen und die von diesen kontaktierten Stifte 25 werden von Ausgängen der Schaltungsanordnung der Leiterplatte 9 Betriebsspannungen entsprechend einem Steuerprogramm ausgegeben.

Die Stifte 25 der Messerleisten 22, 23 und der zugehörigen Schraub-Steckklemmen 26, 27 sind vorzugsweise für die Ausgabe von Steuer- bzw. Betriebsspannungen vorgesehen und mit entsprechenden Bauelementen der Schaltungsanordnung verbunden. Schaltungstechnisch sind die Ausgänge kurzschlußfest ausgebildet.

Die Stifte 25 der Messerleiste 24 sind je mit Eingängen von Eingabeschaltungen auf der Leiterplatte 9 verbunden. die Eingänge sind für die Erfassung von binären Werten zugeordneter Signalpegel bestimmt. An den Stiften 25 der Messerleiste 24 und den Kontakten der dieser Messerleiste durch die Codierung zugeordneten Schraub-Steckklemme 28 werden deshalb vorzugsweise Ausgänge von Sensoren wie Endschalter oder Initiatoren angelegt.

Es ist aber auch möglich, die Betriebsspannung von Stellelementen wie Relais und Spulenvon Magnetventilen zu überprüfen, indem, wie in Fig. 11 dargestellt, bei einem Anschluß der Leitungen 63, 64, 66 gem. Fig. 10 eine zusätzliche Leitung 65 zwischen der Schraub-Steckklemme 28 bzw. dem zugeordneten Stift 25 der Messerleiste 24 verlegt wird. Hierdurch wird ein Eingang mit der Spule des Relais 62 verbunden, wodurch festgestellt werden kann, ob die Spule des Relais 62 Spannung erhält. Bei der Kurzverbindung 103 wird Drahtbruch der Leitung 64 nicht mitüberwacht.

Die Fig. 12 zeigt eine Schaltungsvariante, bei der ein kontaktloser Initiator 67 mit einer Leitung 68 an einen Eingang der Schaltung über die Schraub-Steckklemme 28, mit einer Leitung 69 an eine Betriebsspannungsquelle (negativer Pol) über die Schraub-Steckklemme 26 und mit einer Leitung 70 an die Stromschlene 33 angeschlossen ist, die in diesem Fall an das positive Potential der Betriebsspannung gelegt ist.

Ein weiterer, Zweileiteraktor 70 ist in der gleichen senkrechten Reihe an die Schraub-Steckklemme 27, die Ausgänge für Steuersignale aufweist, und gemeinsam mit der Leitung 69 an den gleichen Anschluß der Schraub-Steckklemme 26 gelegt.

Bei Vierdraht-Aktoren müssen der Sensorausgang des Aktors an eine Klemme der Schraub-Steckklemme 28, der Schutzleiter an die Schiene 33 und die Eingänge für positives und negatives Potential an die in der gleichen senkrechten Reihe angeordneten Klemmen der Schraub-Steckklemmen 26 und 27 angeschlossen werden.

Die vier Kontaktelemente je einer senkrechten Reihe können auch sowohl zur Verbindung mit einem Zweidrahtsensor, z. B. einem Endschalter, und mit einem Zweidraht-Aktor, z. B. einer Relaisspule, verwendet werden. Der Zweidraht-Sensor wird dann jeweils an ein Kontaktelement der Schraub-Steckklemme 28 und an die mit positivem Betriebsspannungspotential beaufschlagte Schiene 33 angeschlossen. Die Relaisspule wird in der gleichen senkrechten Reihe bzw. Spalte an die Klemmen der Schraub-Steckklemmen 26, 27 angeschlossen.

Die Fig. 13 zeigt die Anschlußmöglichkeiten von Aktoren mit Schutzleitern. Ein Vierdraht-Sensor 72 ist mit dem Schutzleiter an die Schiene 33 angeschlossen. Die Leitungen 73 und 74 für die Stromversorgung sind an die Klemmen der Schraub-Steckklemmen 26 und 27 angeschlossen, die jeweils von der Betriebsspannung beaufschlagt werden. Der Sensor-Ausgang ist mit der Klemme der Schraub-Steckklemme 28 verbunden, der eine Eingabe der Schaltung auf der Leiterplatte 9 zugeordnet ist. Ein Vierdraht-Aktor der oben beschriebenen Art benötigt also vier in einer senkrechten Reihe angeordnete Anschlüsse. Für einen Dreileiter-Aktor 75, z. B. einer Spule eines Magnetventils, das einen Schutzleiter enthält, müssen dann die Klemmen der benachbarten senkrechten Reihe der Schraub-Steckklemmen 26 bis 28 belegt werden. Neben dem Anschluß des Schutzleiters an die Schiene 33 werden die beiden anderen Leitungen 76, 77 des Aktors 75 an die Klemmen der Schraub-Steckklemmen 26 und 27 angeschlossen.

Die oben beschriebene Baugruppe eignet sich für Eingabe/Ausgabe-Baugruppen. In der oben beschriebenen Anordnung bilden solche Baugruppen eine Prozeß-Schnittstelle mit kleinstmöglichem Volumen.

Es ist aber auch möglich, im Gehäuse eine vollständige speicherprogrammierbare Steuerung anzuordnen, d. h. eine Steuerung, die wenigstens einen Prozessor, Speicher und Eingabe-ausgabeschaltungen enthält.

Die speicherprogrammierbare Steuerung führt nach einem Programm datenverarbeitende Operationen, insbesondere auch solche, wie logische Verknüpfungen aus. In einem Programmspeicher sind diese Verknüpfungsanweisungen gespeichert. Das Programm legt fest, welche Eingangsdaten vom Prozessor aufgenommen und wie sie zu verarbeiten sind sowie die Ausgabeelemente, an die das Ergebnis der Verarbeitung gelangen soll.

Eine Baugruppe mit der vorstehend beschriebenen speicherprogrammierbaren Steuerung kann bei geringem Verdrahtungsaufwand prozeßnah installiert werden. Durch die Anschlußmöglichkeit an einen Bus ist eine solche Einheit slave-fähig in offenen Systemen.

Durch eine Öffnung 100 in Teil 13, Fläche 20, kann mittels handelsüblicher Zylinderschrauben eine Montage auf einer Schaltschrankmontageplatte erfolgen.

Über die Schirmfläche 101 im lay-out der Leiterplatte 9 kontaktiert der Schraubenkopf der Schraube 102 direkt zur Schrankmasse und führt damit ohne Zusatzaufwand die EMV-Störungen ab, da bei dieser Montageart die Massefeder 60 außer Funktion ist. Die Schraube 102 ist in Fig. 1 in Explosivdarstellung gezeigt.

## Patentansprüche

1. Baugruppe eines Automatisierungsgerätes mit einem zweiteiligen Gehäuse, wobei ein rückwärtiger Teil auf einer Tragschiene aufschnappbar ist und ein vorderer Teil in Reihen und in Abständen parallel und mit gleichem Aufbau fluchtend zueinandergeordnete Anschlusselemente für von außen an die Baugruppe herangeführte Leitungen für die Ein- und/oder Ausgabe von Signalen und/oder Betriebsspannungen von oder zu Aktoren sowie Anzeigeelemente aufweist,
**dadurch gekennzeichnet,**
dass die Baugruppe (10) wenigstens eine mit Bauelementen mindestens einer elektrischen Schaltung bestückte Leiterplatte (9) enthält, auf der wenigstens drei Steckverbinderleisten (22, 23, 24) angeordnet sind, dass jeweils drei Kontaktelemente je aus einer Steckverbinderleiste (22, 23, 24) längs einer geraden Linie (28 a) angeordnet und jeweils für die Signaleingabe, die Signal ausgabe oder für Betriebsspannungen vorgesehen sind, dass der vordere Teil (23) mit Ausnehmungen (29, 30, 31, 34) einerseits für den Zugang zu den Steckverbinderleisten (22, 23, 24)und andererseits als Fenster für auf der Leiterplatte (9) angeordnete optische Anzeigeelemente (35) versehen ist, die jeweils längs der Linie (28 a) im Abstand von den Kontaktelementen der Steckverbinderleisten angeordnet sind und Pegel auf diesen Kontaktelementen anzeigen und dass auf den Steckverbinder (22, 23, 24) Gegensteckverbinderleisten befestigbar sind, an deren Kontaktelementen die Enden der von außen herangeführten Leitungen befestigt sind.

2. Baugruppe nach Anspruch 1,
**dadurch gekennzeichnet,**
dass auf der Leiterplatte (9) eine zu den Steckverbinderleisten (22,23, 24) parallele ein- oder mehrreihige Stromschiene (33) angebracht ist, die wenigstens eine der Anzahl der Kontaktelemente der Steckverbinderleisten entsprechende Zahl von Anschlusselementen hat, die je in einer Linie (28a) mit zugeordneten Kontaktelementen der Steckverbinderleisten (22, 23, 24) liegen und über eine Aussparung (32) im vorderen Teil (13) des Gehäuses zugänglich sind.

3. Baugruppe nach Anspruch 2,
**dadurch gekennzeichnet,**
daß die Steckverbinderleisten (22, 23, 24) und die Stromschiene (33) bei an einer ortsfesten Tragschiene (14) montierter Baugruppe (10) waagrecht im unteren Bereich der Baugruppe angeordnet sind.

4. Baugruppe nach einem oder mehreren der vorhergehenden Ansprüche,
**dadurch gekennzeichnet,**
daß auf einer Wand (41) des Gehäuses, die an die Fenster für die optischen Anzeigeelemente angrenzt, ein Beschriftungsfeld (42) mit Abschnitten, die zu den einer externen Einheit zugeordneten Kontaktelementen der Steckverbinderleisten (22, 23, 24) und den zugeordneten Anzeigeelementen (35) fluchten, angeordnet ist.

5. Baugruppe nach einem oder mehreren der vorhergehenden Ansprüche,
**dadurch gekennzeichnet,**
daß die Steckverbinderleisten (22, 23, 24) auf der Leiterplatte (9) als Messerleisten ausgebildet sind.

6. Baugruppe nach einem oder mehreren der vorhergehenden Ansprüche,
**dadurch gekennzeichnet,**
daß auf die Messerleisten wahlweise Federzug-Steckklemmen oder Schraub-Steckklemmen (26, 27, 28) aufsteckbar sind und daß die Messerleisten (22, 23, 24) an den Stirnseiten mit von Hand betätigbaren Auswerfern (44) für die Federzug-Steckklemmen (26) oder Schraub-Steckklemmen (26, 27, 28) versehen sind.

7. Baugruppe nach einem oder mehreren der vorhergehenden Ansprüche,
**dadurch gekennzeichnet,**
daß die Messerleisten (22, 23, 24) und die Federzug-Steckklemmen (26) oder die Schraub-Steckklemmen (26, 27, 28) mit mechanischen Codiermitteln versehen sind.

8. Baugruppe nach einem oder mehreren der vorhergehenden Ansprüche,
**dadurch gekennzeichnet,**
daß der vordere Teil (13) des Gehäuses einen die Steckverbinderleisten (22, 23, 24) umgebenden ersten Abschnitt (20) mit kleinerer Tiefe und einen an den ersten Abschnitt angrenzenden zweiten Abschnitt (21) aufweist, der eine größere Tiefe hat.

9. Baugruppe nach einem oder mehreren der vorhergehenden Ansprüche,
**dadurch gekennzeichnet,**
daß in einer Stufe (40) zwischen dem ersten und zweiten Abschnitt (20, 21) Lüftungsöffnungen (52) vorgesehen sind.

10. Baugruppe nach einem oder mehreren der vorhergehenden Ansprüche,
**dadurch gekennzeichnet,**
daß nahe an zwei Ecken der Leiterplatte (9), die der Seite mit den Steckverbinderleisten entgegengesetzt sind, je ein Steckverbinder (58, 59) angebracht ist, der im zweiten Abschnitt (21) des vorderen Teils (13) des Gehäuses über eine Öffnung zugänglich ist, die in der Wand, die der Stufe (40) entgegengesetzt ist, angebracht ist.

11. Baugruppe nach einem oder mehreren der vorhergehenden Ansprüche,
**dadurch gekennzeichnet,**
daß auf der Leiterplatte (9) eine Leiterbahn oder metallische Fläche gegen eine vom Gehäuse gehaltene Feder (60) andrückbar ist, die mit einem Teil durch eine Öffnung im Gehäuse in montierter Stellung der Baugruppe an die Tragschiene (14) angedrückt ist.

12. Baugruppe nach einem oder mehreren der vorhergehenden Ansprüche,
**dadurch gekennzeichnet,**
daß auf der Wand (42) des zweiten Abschnitts (21) des vorderen Teils (13) des Gehäuses eine Farbcodierung angebracht ist.

13. Baugruppe nach einem oder mehreren der vorhergehenden Ansprüche,
**dadurch gekennzeichnet,**
daß das Gehäuse aus Polycarbonat besteht.

14. Baugruppe nach einem oder mehreren der vorhergehenden Ansprüche,
**dadurch gekennzeichnet,**
daß die Schaltungsanordnung eine an einen Bus anschließbare Ein-, Ausgabebaugruppe ist.

15. Baugruppe nach einem oder mehreren der Ansprüche 1 - 13,
**dadurch gekennzeichnet,**
daß die Schaltungsanordnung eine für sich funktionsfähige und/oder slave fähige speicherprogrammierbare Steuerung enthält.

16. Baugruppe nach einem oder mehreren der Ansprüche 1 bis 10,
**dadurch gekennzeichnet,**
daß im vorderen Teil (13) des Gehäuses eine Öffnung (100) vorgesehen ist, mit der eine metallische Schirmfläche auf der Leiterplatte (9) an einer metallischen, am rückwärtigen Teil (12) anliegenden Platte anschließbar ist.

17. Baugruppe nach einem oder mehreren der vorhergehenden Ansprüche,
**dadurch gekennzeichnet,**
daß an die Stifte (25) der mit Schaltungen zur Ausgabe von Steuer- bzw. Betriebsspannungen verbundenen Messerleisten (22, 23) zweipolige Stellelemente angeschlossen sind und daß jeweils ein Anschluß mindestens eines Stellelements über eine gesonderte Leitung (65) an einen Stift (25) einer Messerleiste (24) angeschlossen ist, die mit einer Schaltung zur Eingabe binärer Signale verbunden ist.

## Claims

1. A module of an automation unit with a two-part housing, where a rear part can be snapped onto a mounting rail and a front part has connection elements in rows and parallel-spaced arranged flush with one another having the same design, for lines routed from the outside to the module for the input and/or output of signals and/or operating voltages from or to actuators and display elements,
**wherein**
the module (10) contains at least one printed circuit board (9) provided with components of at least one electrical circuit and on which are arranged at least three plug-in connector strips (22, 23, 24), wherein three contacts each from one plug-in connector strip (22, 23, 24) each are disposed along a straight line (28a) and are intended for signal input, signal output or operating voltages respectively, wherein the front part (23) is provided with recesses (29, 30, 31, 34) on the one hand for access to the plug-in connector strips (22, 23, 24) and on the other hand as windows for optical display elements (35) disposed on the printed circuit board and in each case along the line (28a) at a distance from the contacts of the plug-in connector strips and indicating levels on these contacts, and wherein mating plug-in connector strips to whose contacts are attached the ends of the lines routed from the outside are attachable to the plug-in connector strips (22, 23, 24).

2. Module according to Claim 1,
**wherein**
a single-row or a multi-row bus bar (33) parallel to the plug-in connector strips (22, 23. 24) is attached to the printed circuit board and has at least a number of connection elements corresponding to the number of contacts of the plug-in connector strips, each contact element being in a line (28a) with associated contacts of the plug-in connector strips (22, 23, 24) and accessible via a recess (32) in the front part (13) of the housing.

3. Module according to Claim 2,
**wherein**
the plug-in connector strips (22, 23, 24) and the bus bar (33) are arranged horizontally in the lower part of the module when the module (10) is mounted on a stationary mounting rail (14).

4. Module according to one or more of the preceding claims,
**wherein**
a legend field (42) with sections is disposed on a wall (41) of the housing adjacent to the windows for the optical display elements, said sections being flush with the contact elements, associated with an external unit, of the plug-in connector strips (22, 23, 24) and with the associated display elements (35).

5. Module according to one or more of the preceding claims,
**wherein**
the plug-in connector strips (22, 23, 24) on the printed circuit board (9) are designed as male connectors.

6. Module according to one or more of the preceding claims,
**wherein**
optionally spring-mounted plug-in terminals or screw-mounted plug-in terminals (26, 27, 28) are mountable onto the male connectors, and wherein the male connectors (22, 23, 24) on the front sides are provided with manually actuable ejectors (44) for the spring-mounted plug-in terminals (26) or screw-mounted plug-in terminals (26, 27, 28).

7. Module according to one or more of the preceding claims,
**wherein**
the male connectors (22, 23, 24) and the spring-mounted plug-in terminals (26) or screw-mounted plug-in terminals (26, 27, 28) are provided with mechanical coding means.

8. Module according to one or more of the preceding claims,
**wherein**
the front part (13) of the housing has a first section (20) of low depth surrounding the plug-in connector strips and a second section (21) of greater depth adjacent to the first section.

9. Module according to one or more of the preceding claims,
**wherein**
air apertures (52) are provided in a step (40) between the first and second sections (20, 21).

10. Module according to one or more of the preceding claims,
**wherein**
one plug-in connector (58, 59) each is attached close to those two corners of the printed circuit board (9) opposite to the side with the plug-in connector strips and is accessible in the second section (21) of the front part (13) of the housing via an aperture provided in the wall opposite the step (40).

11. Module according to one or more of the preceding claims,
**wherein**
a printed conductor or metallic surface on the printed circuit board (9) can be pressed against a spring (50) held by the housing and is pressed with one part against the mounting rail (14) through an opening in the housing in the mounted position of the module.

12. Module according to one or more of the preceding claims,
**wherein**
a color coding is provided on the wall (42) of the second section (21) of the front part (13) of the housing.

13. Module according to one or more of the preceding claims,
**wherein**
the housing comprises polycarbonate.

14. Module according to one or more of the preceding claims,
**wherein**
the circuit array is an input/output module connectable to a bus.

15. Module according to one or more of Claims 1 - 13,
**wherein**
the circuit array contains a stored-program control operational per se and/or with slave capability.

16. Module according to one or more of the Claims 1 - 10,
**wherein**
an aperture (100) is provided in the front part (13) of the housing using which a metallic shielding surface on the printed circuit board (9) is connectable to a metallic plate contacting the rear part (12).

17. Module according to one or more of the preceding claims,
**wherein**
two-pin setting elements are connected to the pins (25) of the male connectors (22, 23) that are connected to circuits for output of control or operating voltages, and wherein one connection of at least one setting element is connected via a separate line (65) to a pin (25) of a male connector (24) that is connected to a circuit for input of binary signals.

## Revendications

1. Bloc d'un appareil d'automatisation avec un boîtier en deux parties, une partie arrière étant verrouillable par ressort sur un profilé support et une partie avant présentant des éléments de raccordement disposés en rangée et en distance parallèlement et alignés les uns par rapport aux autres avec la même structure, destinés aux conduites amenées au bloc de l'extérieur pour l'entrée et la sortie de signaux et/ou de tensions de service venant de ou envoyés vers des acteurs, ainsi que des éléments d'affichage,
**caractérisé en ce**
que le bloc (10) contient au moins une carte imprimée (9) équipée d'éléments supports d'au moins un circuit électrique, sur laquelle sont disposées au moins trois réglettes de connecteurs (22, 23, 24), que trois éléments de contact sortant respectivement d'une réglette (22, 23, 24) sont disposés le long d'une ligne droite (28a) et sont respectivement prévus pour l'entrée de signaux, la sortie de signaux ou de tensions de service, que la partie avant (23) est munie de creux (29, 30, 31, 34) d'une part pour l'accès aux réglettes de connecteurs (22, 23, 24) et d'autre part faisant fonction de fenêtre pour les éléments d'affichage optiques (35) disposés sur la carte imprimée (9), qui sont respectivement disposés le long de la ligne (28a) à distance des éléments de contact des réglettes de connecteurs et affichent le niveau sur ces éléments de contact, et que peuvent être fixées aux connecteurs (22, 23, 24) des réglettes de contre-connecteurs aux éléments de contact desquelles sont fixées les extrémités des conduites amenées de l'extérieur.

2. Bloc selon la revendication 1,
**caractérisé en ce**
que sur la carte imprimée (9) est placée parallèlement aux réglettes de connecteurs (22, 23, 24) un rail de contact à une ou plusieurs rangées (33), qui a un nombre d'éléments de raccordement correspondant au moins au nombre d'éléments de contact des réglettes de connecteurs, qui sont alignés selon la ligne (28a) sur des éléments de contact des réglettes de connecteurs (22, 23, 24) qui leur sont affectés et qui sont accessibles par un évidement (32) pratiqué dans la partie avant (13) du boîtier.

3. Bloc selon la revendication 2,
caractérisé en ce
que les réglettes de connecteurs (22, 23, 24) et le rail de contact (33) sont placés horizontalement dans la zone inférieure d'un bloc (10) monté sur un profilé support (14) fixé à demeure.

4. Bloc selon l'une ou plusieurs des revendications précédentes,
caractérisé en ce
que sur un panneau (41) du boîtier adjacent à la fenêtre pour les éléments d'affichage optiques est disposé une case d'inscription (42) avec des sections alignées sur les éléments de contact des réglettes de connecteurs (22, 23, 24) affectés à une unité externe et sur les éléments d'affichage affectés (35).

5. Bloc selon l'une ou plusieurs des revendications précédentes,
caractérisé en ce
que les réglettes de connecteurs (22, 23, 24) sur la carte imprimée (9) sont conçues sous forme de réglettes de contacts à couteau.

6. Bloc selon l'une ou plusieurs des revendications précédentes,
caractérisé en ce
que sur les réglettes de contacts à couteau peuvent être enfichées au choix des bornes à fiches à ressort ou des bornes à fiches à vis (26, 27, 28), et que les réglettes de contacts à couteau (22, 23, 24) sont munies à l'avant d'éjecteurs (44) à commande manuelle pour les bornes à fiches à ressort (26) ou les bornes à fiches à vis (26, 27, 28).

7. Bloc selon l'une ou plusieurs des revendications précédentes,
caractérisé en ce
que les réglettes de contacts à couteau (22, 23, 24) et les bornes à fiches à ressort (26) ou les bornes à fiches à vis (26, 27, 28) sont munies de moyens de codage mécaniques.

8. Bloc selon l'une ou plusieurs des revendications précédentes,
caractérisé en ce
que la partie avant (13) du boîtier présente une première section (20) entourant les réglettes de connecteurs (22, 23, 24) qui a une moindre épaisseur, et une deuxième section (21) adjacente à la première section qui a une épaisseur supérieure.

9. Bloc selon l'une ou plusieurs des revendications précédentes,
caractérisé en ce
que dans un décrochement (40) entre la première et la deuxième section (20, 21) sont prévus des orifices d'aération (52).

10. Bloc selon l'une ou plusieurs des revendications précédentes,
caractérisé en ce
qu'a proximité de chacun des deux angles de la carte imprimée (9) qui sont opposés au côté avec les réglettes de connecteurs est disposé un connecteur (58, 59) qui est accessible dans la deuxième section (21) de la partie avant (13) du boîtier par un orifice pratiqué dans le panneau opposé au décrochement (40).

11. Bloc selon l'une ou plusieurs des revendications précédentes,
caractérisé en ce
que sur la carte imprimée (9) une voie conductrice ou une surface métallique peut être pressée contre un ressort (60) maintenu par le boîtier, dont une partie est pressée contre le profilé support (14) à travers un orifice du boîtier quand le bloc est en position de montage.

12. Bloc selon l'une ou plusieurs des revendications précédentes,
caractérisé en ce
que sur le panneau (42) de la deuxième section (21) de la partie avant (13) du boîtier est apposé un codage de couleurs.

13. Bloc selon l'une ou plusieurs des revendications précédentes,
caractérisé en ce
que le boîtier est en polycarbonate.

14. Bloc selon l'une ou plusieurs des revendications précédentes,
caractérisé en ce
que la structure du circuit est un bloc d'entrée et de sortie pouvant être connecté à un bus.

15. Bloc selon l'une ou plusieurs des revendications 1 à 13,
caractérisé en ce
que la structure du circuit comprend une commande à programme enregistrable pouvant fonctionner d'elle-même et/ou en tant qu'esclave.

16. Bloc selon l'une ou plusieurs des revendications 1 à 10,
caractérisé en ce
que dans la partie avant (13) du boîtier est prévu un orifice (100) avec lequel une surface de blindage sur la carte imprimée (9) peut être connectée à une plaque métallique placée contre la partie arrière (12).

17. Bloc selon l'une ou plusieurs des revendications précédentes,
caractérisé en ce
que les broches (25) des réglettes de contacts à couteau (22, 23) qui sont reliées à des circuits de sortie de tensions de commande ou de service sont connectées à des éléments de commande bipolaires, et que respectivement un raccord d'au moins un élément de commande est connecté au moyen d'une conduite séparée (65) à une broche (25) d'une réglette de contacts à couteau (24), qui est reliée à un circuit d'entrée de signaux binaires.
